Europäisches Patentamt

European Patent Office

Office européen des brevets

(11) Veröffentlichungsnummer: **0 248 270**
**A2**

# (12) EUROPÄISCHE PATENTANMELDUNG

(21) Anmeldenummer: 87107290.6

(22) Anmeldetag: **19.05.87**

(51) Int. Cl.4: **H01L 27/08** , H03K 19/094 , H01L 29/60

(30) Priorität: **06.06.86 DE 3619015**

(43) Veröffentlichungstag der Anmeldung:
**09.12.87 Patentblatt 87/50**

(84) Benannte Vertragsstaaten:
**AT DE FR GB IT NL**

(71) Anmelder: **Siemens Aktiengesellschaft Berlin und München**
**Wittelsbacherplatz 2**
**D-8000 München 2(DE)**

(72) Erfinder: **Köppe, Siegmar, Dipl.-Ing.**
**Am Kamp 18**
**D-3014 Laatzen(DE)**

(54) **Logische Schaltung.**

(57) Logische Schaltung mit einer Mehrzahl von auf einem dotierten Halbleiterkörper (4) integrierten Feldeffekttransistoren (T1, T3). Zur Erhöhung der Fehlertoleranz ist an wenigstens einem Schaltungseingang (E1) eine schleifenförmig in sich geschlossene Gateleitung (9) vorgesehen, die mit diesem Schaltungseingang (E1) leitend verbunden ist und so ausgebildet ist, daß die Gateelektroden der über den Schaltungseingang anzusteuernden Feldeffekttransistoren (T1, T3) durch Teile der Gateleitung (9) gebildet werden.

FIG 2

EP 0 248 270 A2

## Logische Schaltung

Die Erfindung bezieht sich auf eine logische Schaltung nach dem Oberbegriff des Patentanspruchs 1.

Bei Schaltungen dieser Art besteht die Schwierigkeit, daß Unterbrechungsfehler (stuck-open-Fehler) in den Zuleitungen zu den Gateelektroden der Feldeffekttransistoren mittels eines der üblichen Verfahren zur automatischen Fehlererkennung - schwer festzustellen sind. Diese Verfahren beruhen im einzelnen darauf, daß den Eingängen der zu überprüfenden Schaltung eine Folge von Test-Bitmustern zugeführt wird, von denen wenigstens eines so beschaffen ist, daß es für die Erkennung eines bestimmten Fehlers geeignet ist, d.h. zu einem an den Schaltungsausgängen abgreifbaren Ausgangs-Bitmuster führt, das von dem bei Fehlerfreiheit zu erwartenden Ausgangssollmuster in wenigstens einem Bit abweicht. Unterbrechungsfehler in den Gatezuleitungen sind nun insbesondere deswegen problematisch, weil kein eindeutiges Modell für die Fehlersimulation bereitgestellt werden kann. Der Grund hierfür liegt darin, daß das Verhalten des betreffenden Feldeffekttransistors von der jeweiligen Ladung bzw. dem Potential auf seiner sich in einem "floatenden" Zustand befindenden Gateelektrode abhängig ist. Dieses Potential ist aber unbekannt.

Der Erfindung liegt die Aufgabe zugrunde, eine Schaltung der eingangs genannten Art anzugeben, die fehlertoleranter ausgebildet ist als herkömmliche Schaltungen dieser Art. Das wird erfindungsgemäß durch eine Ausbildung nach dem kennzeichnenden Teil des Patentanspruchs 1 erreicht. Der mit der Erfindung erzielbare Vorteil besteht insbesondere darin, daß durch die Anwendung der einem Eingang zugeordneten, in sich - schleifenförmig geschlossenen Gateleitung, die die Gateelektroden aller über diesen Eingang anzusteuernden Feldeffekttransistoren als Abschnitte oder Teilabschnitte enthält, ein Unterbrechungsfehler in der Gateleitung die Funktionsfähigkeit der über diese angesteuerten Feldeffekttransistoren in keiner Weise beeinträchtigt. Durch die hierbei erreichte Fehlertoleranz wird die Testbarkeit einer solchen Schaltung ganz wesentlich verbessert.

Die Ansprüche 2 bis 7 sind auf bevorzugte Ausgestaltungen und Weiterbildungen gerichtet.

Die Erfindung wird nachfolgend anhand von in der Zeichnung dargestellten, bevorzugten Ausführungsbeispielen näher erläutert. Dabei zeigt:

Fig. 1 die Prinzipschaltung eines an sich bekannten NAND-Gatters,

Fig. 2 ein nach der Erfindung ausgebildetes NAND-Gatter mit zwei Eingängen in Draufsicht,

Fig. 3 die Prinzipschaltung einer an sich bekannten mehrstufigen Inverterschaltung,

Fig. 4 eine erfindungsgemäße Inverterschaltung der in Fig. 3 angedeuteten Art,

Fig. 5 die Prinzipschaltung eines Teils einer komplexen Gatterstruktur und

Fig. 6 eine erfindungsgemäß ausgebildete Gatterstruktur, die eine Realisierung der Schaltung nach Fig. 5 darstellt.

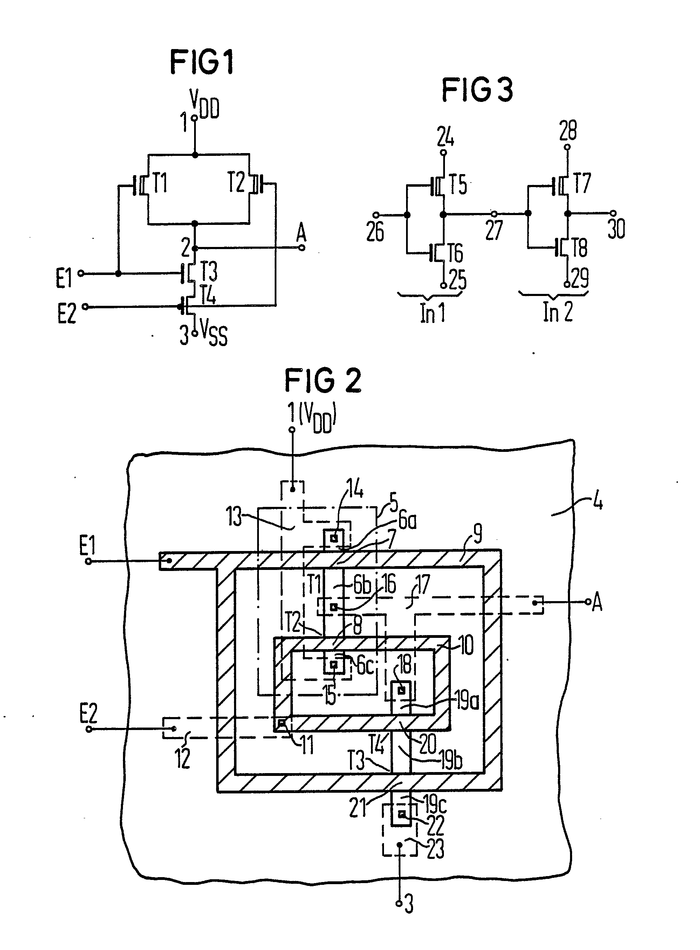

Das in Fig. 1 dargestellte, in komplementärer Schaltkreistechnik ausgebildete NAND-Gatter weist zwei mit ihren Source-Drain-Strecken einander parallel geschaltete p-Kanal-Feldeffekttransistoren T1 und T2 auf. Die Sourceanschlüsse beider Transistoren liegen an einem Anschluß 1, der mit der Versorgungsspannung $V_{DD}$ beschaltet ist, während die Drainanschlüsse mit einem Schaltungspunkt 2 verbunden sind. Dieser ist einerseits mit dem Gatterausgang A und andererseits über die Serienschaltung zweier n-Kanal-Feldeffekttransistoren T3 und T4 mit einem auf Bezugspotential $V_{SS}$ liegenden Anschluß 3 verbunden. Die Gateelektroden von T1 und T3 sind mit einem Eingang E1 beschaltet, die Gateelektroden von T2 und T4 mit einem Eingang E2.

Fig. 2 zeigt eine erfindungsgemäß ausgebildete, die NAND-Funktion nach Fig. 1 realisierende logische Schaltung in Draufsicht. Dabei ist ein dotierter Halbleiterkörper 4, z.B. aus p-leitendem Silizium, mit einer n-leitenden Wanne 5 versehen, die sich bis zu der in Fig. 2 sichtbaren Grenzfläche von 4 erstreckt und in lateraler Richtung durch eine strichpunktierte Linie begrenzt wird. In diese Wanne 5 sind p-leitende Zonen 6a, 6b und 6c eingefügt. Zwischen 6a und 6b befindet sich ein n-leitendes Teilgebiet 7 der Wanne 5, zwischen 6b und 6c ein weiteres n-leitendes Teilgebiet 8 dieser Wanne. Ein Streifen 9 aus polykristallinem Silizium, der durch eine dünne, elektrisch isolierende Schicht von der sichtbaren Grenzfläche des Halbleiterkörpers 4 getrennt ist, bildet eine - schleifenförmig in sich geschlossene Gateleitung, die mit einem Anschluß versehen ist, der dem Eingang E1 der Gatterschaltung entspricht. Das Teilgebiet 7 stellt das Kanalgebiet von T1 dar, der das Teilgebiet 7 überdeckende Abschnitt des Streifens 9 die Gateelektrode und die Zonen 6a und 6b jeweils das Source-und Draingebiet dieses Transistors.

Die Zonen 6b und 6c stellen das Draingebiet und das Sourcegebiet des Transistors T2 dar, das Teilgebiet 8 der Wanne 5 das Kanalgebiet dieses Transistors. Seine Gateelektrode besteht aus dem das Teilgebiet 8 überdeckenden Abschnitt eines weiteren Streifens 10 aus polykristallinem Silizium, der ebenfalls durch eine elektrisch isolierende Schicht von der sichtbaren Grenzfläche des Halbleiterkörpers 4 getrennt ist. Oberhalb der Streifen 9 und 10 ist eine elektrisch isolierende Zwischenschicht vorgesehen, die ein Kontaktloch 11 aufweist. Im Bereich dieses Kontaktloches wird der Streifen 10 von einer leitenden Belegung 12 kontaktiert, die einen den Eingang E2 darstellenden Anschluß aufweist. Eine auf der isolierenden Zwischenschicht aufgebrachte, leitende Belegung 13 ist mit dem Anschluß 1 versehen, der mit der Versorgungsspannung $V_{DD}$ beschaltet ist. Sie kontaktiert im Bereich von Kontaktlöchern 14 und 15 die Zonen 6a bzw. 6c. Die mittlere Zone 6b wird im Bereich eines Kontaktloches 16 von einer leitenden Belegung 17 kontaktiert, die etwa T-förmig ausgebildet ist und mit einem Anschluß versehen ist, der dem Gatterausgang A von Fig. 1 entspricht. Außerdem kontaktiert 17 im Bereich eines Kontaktloches 18 eine n-leitende Zone 19a, die in den Halbleiterkörper 4 eingefügt ist. Weitere n-leitende Zonen 19b und 19c sind so angeordnet, daß zwischen 19a und 19b ein p-leitendes Teilgebiet 20 von 4 und zwischen 19b und 19c ein weiteres p-leitendes Teilgebiet 21 des Halbleiterkörpers liegen. 19a und 19b bilden das Drain-und Sourcegebiet des Transistors T4, das Teilgebiet 20 dessen Kanalgebiet und der 20 überdeckende Abschnitt des Streifens 10 die Gateelektrode dieses Transistors.

Schließlich bilden die Zonen 19b und 19c das Draingebiet und das Sourcegebiet des Transistors T3, das p-leitende Teilgebiet 21 das Kanalgebiet und ein das letztere überdeckender Abschnitt des Streifens 9 die Gateelektrode dieses Transistors. Dabei wird 19c im Bereich eines Kontaktloches 22 von einer leitenden Belegung 23 kontaktiert, die mit einem Anschluß versehen ist, der dem Anschluß 3 in Fig. 1 entspricht.

In Fig. 3 sind zwei zueinander in Serie geschaltete Inverterstufen In1 und In2 vorgesehen, von denen In1 einen p-Kanal-Feldeffekttransistor T5 und einen n-Kanal-Feldeffekttransistor T6 enthält. Diese sind mit ihren Source-Drain-Strecken in Serie geschaltet, wobei der obere Anschluß dieser Serienschaltung, der mit der Versorgungsspannung $V_{DD}$ beschaltet ist, mit 24 bezeichnet ist, während der untere Anschluß 25 auf Bezugspotential liegt. Die Gateelektroden von T5 und T6 sind an den Eingang 26 von In1 geführt. Der Verbindungspunkt zwischen T5 und T6 stellt den Ausgang 27 dieser Inverterstufe und gleichzeitig den Eingang von In2 dar. Diese Stufe weist zwei Transistoren T7 und T8 auf und ist in entsprechender Weise ausgebildet. Dabei sind der Schaltungspunkt 28 wieder mit der Versorgungsspannung beschaltet und der Schaltungspunkt 29 auf Bezugspotential gelegt. Der Anschluß 30 bildet den Ausgang von In2.

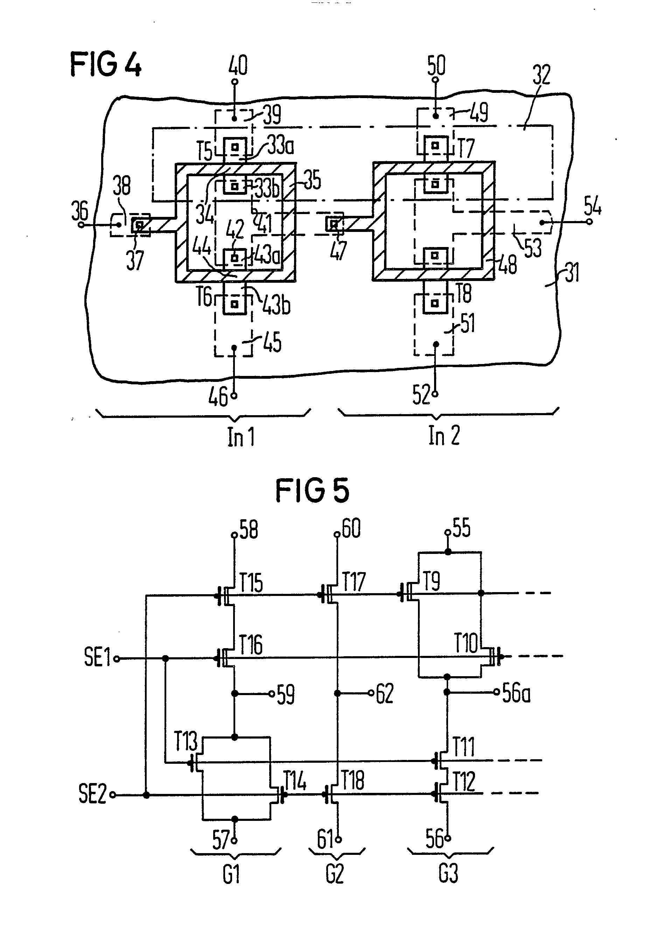

Die in Fig. 4 dargestellte, nach der Erfindung ausgebildete Inverterschaltung ist auf einem dotierten Halbleiterkörper 31, z.B. aus p-leitendem Silizium, integriert, der mit einer n-leitenden, durch eine strichpunktierte Linie begrenzten Wanne 32 versehen ist. In die Wanne sind p-leitende Halbleiterzonen 33a und 33b eingefügt, zwischen denen ein n-leitendes Teilgebiet 34 der Wanne 32 liegt. Ein Streifen 35 aus polykristallinem Silizium, der durch eine dünne elektrisch isolierende Schicht von der sichtbaren Grenzfläche des Halbleiterkörpers 31 getrennt ist, bildet eine schleifenförmige in sich geschlossene Gateleitung, die mit einem Anschluß 36 in Verbindung steht, der dem Eingang 26 in Fig. 3 entspricht. Im einzelnen ist dabei oberhalb des Streifens 35 eine elektrisch isolierende Zwischenschicht vorgesehen, die mit einem Kontaktloch 37 versehen ist. Eine den Streifen 35 hier kontaktierende, leitende Belegung 37 ist mit dem Anschluß 36 versehen. Die Zonen 33a und 33b bilden das Source-und das Draingebiet des Transistors T5, das Teilgebiet 34 das Kanalgebiet und der das letztere überdeckende Abschnitt des Streifens 35 die Gateelektrode dieses Transistors. Dabei ist die Zone 33a im Bereich eines in Fig. 4 dargestellten Kontaktloches mit einer auf der isolierenden Zwischenschicht angeordneten leitenden Belegung 39 verbunden, die über einen Anschluß 40 mit der Versorgungsspannung $V_{DD}$ beschaltet ist.

Die Zone 33b ist in entsprechender Weise mit einer leitenden Belegung 41 verbunden, die über ein weiteres Kontaktloch 42 eine n-leitende Zone 43a kontaktiert, die in den Halbleiterkörper 31 eingefügt ist. Eine in diesen weiterhin eingefügte n-leitende Zone 43b ist nun so angeordnet, daß zwischen 43a und 43b ein p-leitendes Teilgebiet 44 von 31 liegt. Die Zonen 43a und 43b bilden jeweils das Drain-und das Sourcegebiet von T6, das Teilgebiet 44 das Kanalgebiet und der das letztere überdeckende Abschnitt von 35 die Gateelektrode dieses Transistors. Dabei steht die Zone 43b im Bereich eines Kontaktloches mit einer leitenden Belegung 45 in Verbindung, die über einen Anschluß 46 mit dem Bezugspotential der Schaltung belegt ist. Die bisher beschriebenen Teile der Fig. 4 stellen die Inverterstufe In1 von Fig. 3 dar.

Die leitende Belegung 41 kontaktiert im Bereich eines Kontaktloches 47 einen Streifen 48 aus polykristallinem Silizium, der eine streifenförmige in sich geschlossene Gateleitung der Inverterstufe In2 darstellt und durch eine elektrisch isolierende Schicht von der sichtbaren Grenzfläche des Halbleiterkörpers 31 getrennt ist. Dabei entspricht der Bereich des Kontaktloches 47 dem Schaltungspunkt 27 von Fig. 3 und stellt somit den Ausgang von In1 und den Eingang von In2 dar. Der weitere Aufbau von In2 entspricht dem der Stufe In1, wobei der n-Kanal-Transistor T7 innerhalb der Wanne 32, der p-Kanal-Transistor außerhalb derselben liegen. Über eine leitende Belegung 49 ist das Sourcegebiet von T7 mit einem die Versorgungsspannung $V_{DD}$zuführenden Anschluß 50 verbunden. Das Sourcegebiet von T8 ist über eine leitende Belegung 51 und einen Anschluß 52 mit dem Massepotential beschaltet. Eine leitende Belegung 53 stellt eine Verbindung zwischen T7 und T8 her und legt den Verbindungspunkt dieser beiden Transistoren an den Ausgang 54 von In2.

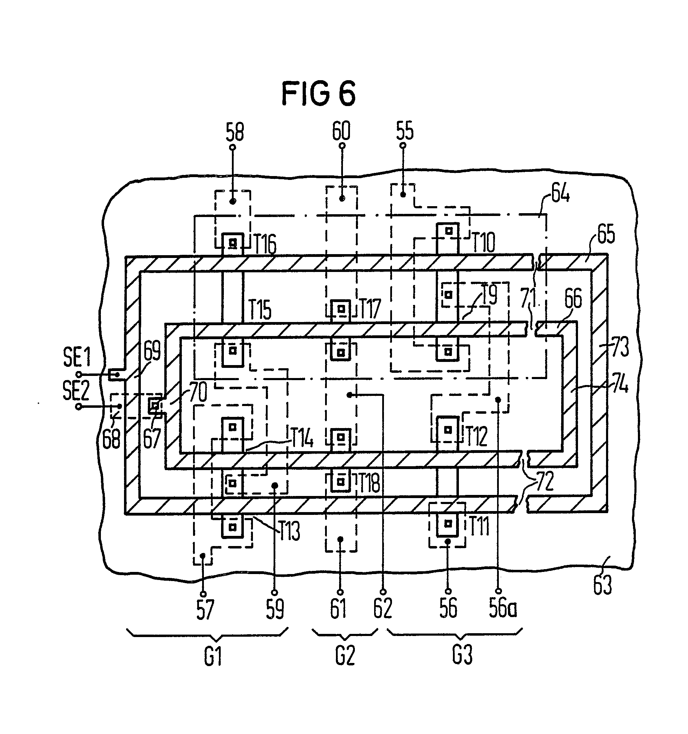

Fig. 5 zeigt das Prinzipschaltbild einer logischen Schaltung, bei der ein NOR-Gatter G1, eine Inverterstufe G2 und ein NAND-Gatter G3 gemeinsam über zwei Schaltungseingänge SE1 und SE2 angesteuert werden. Dabei entspricht das NAND-Gatter G3 mit seinen p-Kanal-Feldeffekttransistoren T9 und T10 und seinen n-Kanal-Feldeffekttransistoren T11 und T12 der Schaltung nach Fig. 1. Der die Versorgungsspannung führende Anschluß ist mit 55 bezeichnet, der auf Bezugspotential liegende Anschluß mit 56 und der Ausgang von G3 mit 56a. Das NOR-Gatter G1 unterscheidet sich von G3 nur dadurch, daß die beiden zueinander parallelen Transistoren T13 und T14 dabei als n-Kanal-Transistoren ausgebildet sind und mit ihren Sourcegebieten über den Anschluß 57 auf Bezugspotential gelegt sind, während die beiden in Serie zueinander liegenden Transistoren T15 und T16 aus p-Kanal-Transistoren bestehen und über den Sourceanschluß von T15 mit dem mit $V_{DD}$ beschalteten Anschluß 58 verbunden sind. Der Ausgang von G1 ist mit 59 bezeichnet. Die Inverterstufe 62, die entsprechend Fig. 3 aufgebaut ist, enthält den p-Kanal-Feldeffekttransistor T17 und den N-Kanal-Feldeffekttransistor T18, die in Serie zueinander geschaltet sind. Das Sourcegebiet von T17 ist mit einem Anschluß 60 verbunden, der mit $V_{DD}$ beschaltet ist, während der Anschluß 61 des Sourcegebietes von T18 auf Bezugspotential liegt. Der Verbindungspunkt 62 von T17 und T18 stellt den Ausgang von G2 dar.

Fig. 6 zeigt eine vorteilhafte, erfindungsgemäße Ausgestaltung der Schaltung nach Fig. 5. Dabei sind die n-Kanal-Transistoren T11 bis T14 und T18 in einem dotierten Halbleiterkörper 63 aus p-leitendem Silizium angeordnet, während die p-Kanal-Transistoren T9, T10, T15, T16 und T17 in einer p-leitenden Wanne 64 angeordnet sind, deren laterale Begrenzung durch die strichpunktierte Linie gegeben ist. Der Aufbau des NAND-Gatters G3 entspricht in allen wesentlichen Merkmalen dem Gatter nach Fig. 2, wobei lediglich die dort seitlich gegeneinander versetzten Transistoren T1, T2 und T3, T4 durch die senkrecht untereinander angeordneten Transistoren T9 bis T12 ersetzt sind. Die Inverterstufe G2 entspricht im wesentlichen der Inverterstufe In1 nach Fig. 4. Schließlich ergibt sich der Entwurf des NOR-Gatters G1 nach Fig. 6 aus dem Entwurf des NAND-Gatters G3 durch eine bloße Vertauschung der innerhalb und außerhalb der Wanne 64 liegenden Feldeffekttransistoren gegeneinander. So liegen bei G1 die einander parallel geschalteten Transistoren T13 und T14 außerhalb von 64, die in Serie geschalteten Transistoren T15 und T16 innerhalb von 64. Die durch gestrichelte Ränder angedeuteten leitenden Belegungen bleiben bei dieser Vertauschung den gleichen Transistorgruppen wie vorher zugeordnet, sind jedoch mit anderen Anschlüssen versehen. So ist die das Sourcegebiet eines der beiden zueinander in Serie liegenden Transistoren (T11) bei G3 mit dem Anschluß 56 verbunden, das entsprechende Gebiet von T16 mit dem Anschluß 58. Die Sourcegebiete der beiden einander parallel geschalteten Transistoren (T9, T10) liegen bei G3 am Anschluß 55, die Sourcegebiete der entsprechenden Transistoren T13, T14 von G1 dagegen am Anschluß 57. Die Ausgänge 59, 62 und 56a der Schaltungsteile G1, G2 und G3 sind in Fig. 6 aus Gründen der Übersichtlichkeit jeweils unterhalb der zugeordneten Teilschaltungen angedeutet.

In Fig. 6 sind zwei schleifenförmig in sich geschlossene Streifen 65 und 66 aus polykristallinem Silizium vorgesehen, die durch eine elektrisch isolierende Schicht von der sichtbaren Grenzfläche des Halbleiterkörpers 63 getrennt sind. Der Streifen 65 ist mit einem Anschluß versehen, der dem Schaltungseingang SE1 von Fig. 5 entspricht. Eine isolierende Zwischenschicht, die oberhalb der Streifen 65 und 66 vorgesehen ist, ist mit einem Kontaktloch 67 versehen. Im Bereich dieses Kontaktloches wird 67 von einer leitenden Belegung 68 kontaktiert, die mit einem Anschluß versehen ist, der dem Schaltungseingang SE2 von Fig. 5 entspricht. Der Streifen 65 stellt für T16, T10, T11 und T13 eine gemeinsame Gateleitung dar, der Streifen 66 eine solche für T15, T17, T9, T12 und T14. Dabei weist die Gateleitung 65 zwei horizontal verlaufende Abschnitte auf, die über eine Verzweigung 69 mit SE1 in Verbindung stehen. Die Gateleitung 66 hat ebenfalls zwei horizontale Abschnitte, die über eine Verzweigung 70 mit SE2 verbunden sind. Bei Einbeziehung weiterer über SE1 und SE2 anzusteuernder Feldeffekttransistoren können die Gateleitungen 65 und 66 beliebig nach rechts verlängert werden, was in Fig. 6 durch die Unterbrechung 71 und 72 angedeutet ist. Die rechtsseitigen Enden der horizontalen Abschnitte von 65 und 66 werden in jedem Fall durch vertikal verlaufende Streifenteile 73 und 74 miteinander verbunden, so daß in sich geschlossene Gateleitungen entstehen.

Die Gateleitungen, z.B. 9, 10, 35, 48, 65 oder 66 können mit Vorteil als Zweischichtenleitungen ausgebildet sein, wobei eine Teilschicht aus polykristallinem Silizium besteht, während die andere z.B. aus einem Silizid gebildet ist. Die Gateleitungen können auch zwischen den die Gateelektroden bildenden Teilen weitere Abschnitte enthalten, die insbesondere aus zu einer anderen Metallisierungsebene gehörenden, leitenden Belegungen gebildet sind und die mit den wenigstens teilweise aus polykristallinem Silizium bestehenden Abschnitten der Gateleitungen über Kontaktierungen verbunden sind. Solche Abschnitte können beispielsweise aus Aluminiumlegierungen, aus Siliziden oder aus Wolfram bestehen.

Bezugszeichenliste

1  Anschluß
2  Schaltungspunkt
3  Anschluß
4  Halbleiterkörper
5  Wanne
6a, b, c  Zonen
7, 8  Teilgebiete von 5
9, 10  polykristalline Streifen
11  Kontaktloch
12, 13  leitende Belegungen
14, 15, 16  Kontaktlöcher
17  leitende Belegung
18  Kontaktloch
19a, b, c  Zonen
20, 21  Teilgebiete von 4
22  Kontaktloch
23  leitende Belegung
24, 25  Anschlüsse
26  Eingang von In1
27  Ausgang von In1
28, 29  Schaltungspunkte
30  Ausgang von In2
31  Halbleiterkörper
32  Wanne
33a, b  Zonen
34  Teilgebiet von 32
35  polykristalliner Streifen
36  Anschluß
37  Kontaktloch
39  leitende Belegung
40  Anschluß
41  leitende Belegung
42  Kontaktloch
43a, b  Zonen
44  Teilgebiet von 31
45  leitende Belegung
46  Anschluß
47  Kontaktloch
48  polykristalliner Streifen
49  leitende Belegung
50  Anschluß
51  leitende Belegung
52  Anschluß
53  leitende Belegung

54  Ausgang von In2
55, 56  Anschlüsse
56a  Ausgang von G3
57, 58  Anschlüsse
59  Ausgang von G1
60, 61  Anschlüsse
62  Ausgang der Inverterstufe G2
63  Halbleiterkörper
64  Wanne
65, 66  polykristalline Streifen
67  Kontaktloch
68  leitende Belegung
69, 70  Verzweigungen
71, 72  Unterbrechungen
73, 74  Streifenteile
T1..T18  Feldeffekttransistoren
A  Gatterausgang
E1, E2  Eingänge
In1, In2  Inverterstufen
G1  NOR-Gatter
G2  Inverterstufe
G3  NAND-Gatter
SE1, SE2  Eingänge

**Ansprüche**

1. Logische Schaltung mit einer Mehrzahl von auf einem dotierten Halbleiterkörper (4) integrierten Feldeffekttransistoren (T1 bis T4), bei der in Abhängigkeit von wenigstens einem logischen Eingangssignal, das den Gateelektroden der Feldeffekttransistoren über wenigstens einen Eingang zugeführt wird, ein logisches Ausgangssignal abgeleitet wird, **dadurch gekennzeichnet,**daß an wenigstens einem der Eingänge (E1) eine - schleifenförmig in sich geschlossene, auf dem Halbleiterkörper (4) angeordnete und durch wenigstens eine elektrisch isolierende Schicht von diesem getrennte Gateleitung (9) vorgesehen ist, die mit diesem Eingang (E1) leitend verbunden ist und so ausgebildet ist, daß die Gateelektroden der über diesen Eingang anzusteuernden Feldeffekttransistoren (T1, T4) durch Teile der Gateleitung (9) gebildet werden.

2. Logische Schaltung nach Anspruch 1, **dadurch gekennzeichnet,** daß die die Gateelektroden bildenden Teile der Gateleitung aus einer Schicht bestehen, die zumindest teilweise aus polykristallinem Silizium besteht, wobei insbesondere eine Teilschicht aus polykristallinem Silizium vorgesehen ist, die durch eine weitere Teilschicht aus einem Silizid zu der genannten Schicht ergänzt ist.

3. Logische Schaltung nach Anspruch 1 oder 2, **dadurch gekennzeichnet,** daß wenigstens ein Abschnitt der Gateleitung, der zwischen den die Gateelektroden bildenden Teilen liegt, aus einer leitenden Belegung besteht, die die letztgenannten Teile kontaktiert.

4. Logische Schaltung nach Anspruch 3, **dadurch gekennzeichnet,** daß die leitende Belegung aus einer Aluminiumlegierung, aus einem Silizid oder aus Wolfram besteht.

5. Logische Schaltung nach einem der vorhergehenden Ansprüche, **dadurch gekennzeichnet,** daß sie in komplementärer Schaltkreistechnik ausgebildet ist und daß jeweils zwei über einen Eingang (E1) ansteuerbare Feldeffekttransistoren (T1, T3) zueinander komplementär sind.

6. Logische Schaltung nach einem der vorhergehenden Ansprüche, **dadurch gekennzeichnet,** daß zwei oder mehrere über einen Eingang (SE1) anzusteuernde Feldeffekttransistoren so angeordnet sind, daß die Gateleitung (65) zwei nebeneinander und etwa parallel zueinander verlaufende Abschnitte aufweist, die über eine Verzweigung (69) mit dem Eingang (SE1) verbunden sind, und daß diese beiden Abschnitte durch eine Verbindungsleitung (73) zu einer Schleife ergänzt werden.

7. Logische Schaltung nach einem der vorhergehenden Ansprüche, **dadurch gekennzeichnet,** daß der Eingang aus dem Eingang einer Schaltungsstufe (In2) besteht, der gleichzeitig den Ausgang einer vorausgehenden Schaltungsstufe (In1) darstellt.

FIG 1

FIG 3

FIG 2

**FIG 4**

**FIG 5**

# FIG 6